(19) **Europäisches Patentamt**

**European Patent Office**

**Office européen des brevets**

(11) **EP 1 667 499 A1**

(12) **EUROPEAN PATENT APPLICATION**
published in accordance with Art. 158(3) EPC

(43) Date of publication:
**07.06.2006 Bulletin 2006/23**

(51) Int Cl.:
*H05H 1/24* (1974.07)    *C08J 7/00* (1974.07)
*B01J 19/08* (1980.01)

(21) Application number: **04772426.5**

(22) Date of filing: **30.08.2004**

(86) International application number:
**PCT/JP2004/012470**

(87) International publication number:
**WO 2005/029926 (31.03.2005 Gazette 2005/13)**

(84) Designated Contracting States:
**DE FR GB NL**

(30) Priority: **18.09.2003 JP 2003325931**

(71) Applicant: **Pearl Kogyo Co., Ltd**
**Osaka-shi,**
**Osaka 559-0015 (JP)**

(72) Inventor: **SAEKI, Noboru**
**c/o Pearl Kogyo Co., Ltd.**
**Osaka 559-0015 (JP)**

(74) Representative: **Fleuchaus, Michael A. et al**
**Fleuchaus & Gallo**
**Melchiorstrasse 42**
**81479 München (DE)**

(54) **PLASMA PROCESSING METHOD AND APPARATUS THEREOF**

(57)    The amount and area of irradiation of excited species to the surface of a workpiece can be increased, the irradiation can be uniformly performed on the whole surface, and the loss of effective excited species is suppressed, so that the treating performance and efficiency can be remarkably improved.

A pulse voltage is applied between discharge electrodes (4) which are opposingly positioned, to produce a corona discharge between pointed ends of the discharge electrodes, and the surface of a workpiece is irradiated with excited species including plasma produced by the corona discharge, thereby treating the surface. The discharge electrodes (4) are configured by a central electrode (11) and two peripheral electrodes (12) (13) opposingly placed in a state where the central electrode (11) is interposed between the peripheral electrodes. The pulse voltage is alternately applied by pulse voltage applying means (16) configured with using an even voltage doubler rectifier circuit to the central electrode (11) and two peripheral electrodes (12) (13) of the discharge electrodes (4). The corona discharge is alternately generated between one of the two peripheral electrodes (12) (13) and the central electrode (11).

Fig. 2

## Description

Technical Field

The present invention is mainly applied to various surface treatments or gas decomposition processes such as those of, in the case where application of a coating composition or printing is performed on a resin such as polyethylene, polypropylene, polyester (PET), or PTFE (polytetrafluoroethylene), modifying the water repellent property of the surface to the water-attracting property, washing away organics adhering to the surface of glass, ceramics, a metal, a semiconductor, or the like, conducting disinfection or sterilization, and performing an etching process, and more particularly to a plasma treating method of the corona discharge type in which a surface treatment such as modification is conducted by irradiating the surface of a workpiece with excited species such as excited molecules, radicals, or ions which are generated as a result of molecular dissociation due to plasma produced by a corona discharge, and an apparatus therefor.

Background Art

A plasma surface treating method of the corona discharge type has an advantage that the use of an ignition gas such as helium, argon, or hydrogen which is required in the case of a plasma surface treating method of the glow discharge type can be omitted, and improvement of the safety in use and reduction of the treatment cost due to a reduced gas consumption can be realized. Therefore, the method is often used in surface treatments such as surface modification.

Important factors in determining the treatment performance and treatment efficiency of this kind of the plasma surface treating method of the corona discharge type are the amount, area, and uniformity of irradiation of excited species including plasma produced by a corona discharge, to the surface of a workpiece. As means for attaining these important factors, conventionally, a pair of discharge electrodes are placed in an opposing state, a sinusoidal AC voltage is applied between the electrodes to generate a corona discharge between the electrodes, and a gas is flown in an area of the discharge (for example, see Patent Reference 1).

Patent Reference 1: Japanese Patent Application Laying-Open No. 2001-293363

Disclosure of the Invention

Problems that the Invention is to Solve

In the above-described conventional plasma surface treating method of the corona discharge type, the amount and area of irradiation of excited species can be adjusted by controlling the ejection pressure of the gas, the ejection angle, and the like. However, since only one discharge region where formation is conducted at a constant interval exists, the adjusting range is naturally restricted, and particularly there is a problem in that a configuration in which the whole surface of a workpiece is averagely evenly irradiated with excited species is difficult structurally and technically.

The invention has been conducted in view of the above-mentioned circumstances. It is an object of the invention to provide a plasma treating method in which the amount and area of irradiation of excited species to the surface of a workpiece can be increased, the irradiation can be uniformly performed on the whole surface, and the loss of effective excited species is suppressed, so that the treating performance and efficiency can be remarkably improved, and an apparatus therefor.

Means for Solving the Problems

In order to attain the object, a plasma treating method of claim 1 of the invention is a plasma treating method in which a pulse voltage is applied to opposing discharge electrodes to produce a corona discharge between pointed ends of the discharge electrodes, and a surface of a workpiece is irradiated with excited species including plasma produced by the corona discharge, thereby treating the surface, wherein

the pulse voltage is alternately applied by pulse voltage applying means configured with using an even voltage doubler rectifier circuit to a central electrode and two peripheral electrodes of the discharge electrodes, the discharge electrodes being configured by the central electrode and the two peripheral electrodes opposingly placed in a state where the central electrode is interposed between the peripheral electrodes, and the corona discharge is alternately generated between one of the two peripheral electrodes and the central electrode.

Furthermore, a plasma treating apparatus of claim 6 of the invention is a plasma treating apparatus in which a pulse voltage is applied to opposing discharge electrodes to produce a corona discharge between pointed ends of the discharge electrodes, and a surface of a workpiece is irradiated with excited species including plasma produced by the corona discharge, thereby treating the surface, wherein

the discharge electrodes are configured by a central electrode and two peripheral electrodes placed to oppose the central electrode, a center terminal of pulse voltage applying means configured with using an even voltage doubler rectifier circuit is connected to the central electrode, side terminals of the pulse voltage applying means are connected to the peripheral electrodes, respectively, and, based on an alternating voltage applied to the central electrode and the peripheral electrodes, the corona discharge is alternately generated between the central electrode and the peripheral electrodes.

Effects of the Invention

According to the invention having the above configuration, the discharge electrodes are configured by the central electrode and the two peripheral electrodes opposingly placed in a state where the peripheral electrodes oppose the central electrode, and the pulse voltage is alternately applied between the central electrode and the peripheral electrodes to alternately cause a discharge. Therefore, a state where two discharging gaps are formed in series is attained, so that the amount and area of irradiation of excited species to the surface of the workpiece can be increased, and the irradiation can be uniformly performed on the whole surface.

In the above-described plasma treating method and apparatus of the corona discharge type, as the pulse voltage applied to the discharge electrodes, any one of a rectangular pulse voltage as set forth in claims 2 and 8, and a pulse voltage configured by plural pulsating waves which are obtained by full-wave rectifying an AC voltage as set forth in claims 3 and 9 may be used. In the case where the pulse voltage configured by pulsating waves is used, particularly, a special pulse voltage generation power source is not necessary, and a simple power source device configured by a combination of an AC power source of a commercial or ultrasonic region and rectifying elements such as diodes can be used. Therefore, it is possible to apply a pulse voltage of a desired period and duty, and realize a cost reduction of the apparatus.

In the case where, as set forth in claims 4 and 10, the pulse voltage is applied to the discharge electrodes in a state where a magnetic field is formed in vicinities of the pointed ends of the discharge electrodes, to generate a corona discharge between the electrodes, excited species including plasma produced by the corona discharge exist in the magnetic field. Therefore, the magnetic field applies a pushing force, i.e., the Lorentz force to a charged particle in plasma moving in the magnetic field, and the excited species can be irradiated toward the surface of the workpiece vigorously and substantially uniformly over a wide area.

As the means for forming the magnetic field in the plasma treating apparatus of the corona discharge type, any one of means configured by a permanent magnet, a pair of magnetic members, and a pair of pole pieces in which a gap is formed between end faces as set forth in claim 11, and that configured by an electromagnet, a pair of magnetic members, and a pair of pole pieces in which a gap is formed between end faces as set forth in claim 12 may be used. In the case where a permanent magnet is used, lowering of the production cost and saving of the power consumption are enabled. By contrast, in the case where an electromagnet is used, the production cost and the power consumption are increased as compared with the case where a permanent magnet is used. However, the Lorentz force, and the irradiation force and irradiation diffusion range of the excited species including plasma can be controlled easily and arbitrarily in accordance with the surface configuration of the workpiece, or the like, by adjusting the magnetic flux in the gap between the end faces of the pole pieces. Therefore, the shape applicability with respect to the workpiece can be enhanced, and the treatment performance and treatment efficiency can be further improved.

In the invention, as set forth in claims 5 and 13, a reactive gas such as argon, nitrogen, or carbon dioxide gas may be introduced between the discharge electrodes at atmospheric pressure or a vicinity of atmospheric pressure. According to the configuration, a flow of the gas causes excited species including plasma to be irradiated toward the surface of the workpiece, and the amount, area, and uniformity of irradiation to the surface of the workpiece can be attained. Moreover, the excitation gas flow is caused to be irradiated, by the pushing action force (Lorentz force) which is received from the magnetic field, whereby the invention can be used in various surface treatments.

Brief Description of the Drawings

[Fig. 1] Fig. 1 is a partially omitted longitudinal section front view showing an embodiment of the plasma treating apparatus of the invention.
[Fig. 2] Fig. 2 is a partially cutaway perspective view of the apparatus of Fig. 1.
[Fig. 3] Fig. 3 is a waveform chart of a pulsating voltage outputted by pulse voltage applying means, Fig. 3a is a waveform chart of an output from a booster, Fig. 3b is a waveform chart of a rectified pulsating voltage which is taken out by a central electrode and a positive electrode, and Fig. 3c is a waveform chart of a rectified pulsating voltage which is taken out by the central electrode and a negative electrode.
[Fig. 4] Fig. 4 is a waveform chart of a rectangular voltage outputted by pulse voltage applying means, Fig. 4a is a waveform chart of an output from a booster, Fig. 4b is a waveform chart of a rectified rectangular voltage which is taken out by a central electrode and a positive electrode, and Fig. 4c is a waveform chart of a rectified rectangular voltage which is taken out by the central electrode and a negative electrode.

Description of Reference Numerals

4 ... discharge electrode, 6, 7 ... pole piece, 8 ... permanent magnet, 11 ... central electrode, 12, 13 ... peripheral electrode (12 ... positive electrode, 13 ... negative electrode), 16 ... pulse voltage applying means, M ... magnetic field forming means.

Best Mode for Carrying Out the Invention

Hereinafter, an embodiment of the invention will be described on the basis of the drawings.

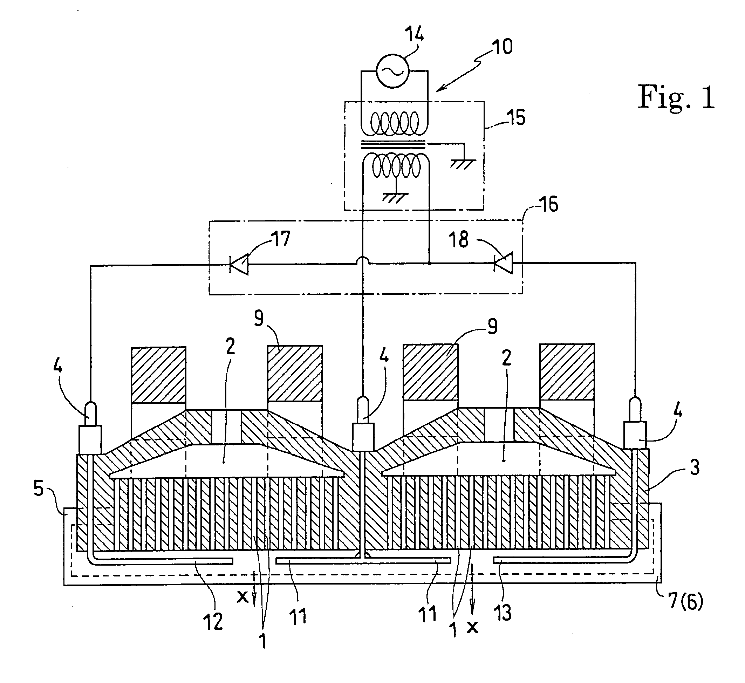

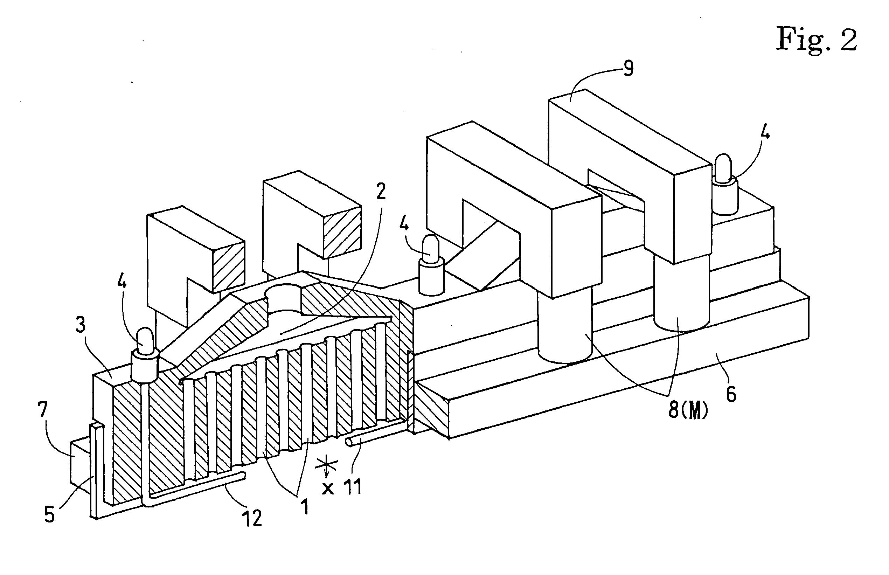

Fig. 1 is a longitudinal section front view showing an embodiment of a plasma surface treating apparatus to which the invention is applied, and Fig. 2 is a partially cutaway perspective view.

The plasma surface treating apparatus is configured by: a plate-like insulating member (3) in which many gas ejection holes (1) are disposed in a row, and a gas reservoir (2) where upper ends portions of the gas ejection holes communicate with each other is formed inside; discharge electrodes (4) which are supported on the plate-like insulating member (3); a pair of ceramics-made insulating spacers (5) which are formed in a state where the discharge electrodes (4) are interposed back and forth; pole pieces (6) (7) which are placed outside the ceramics-made insulating spacers (5), respectively; magnets (8) which are magnetically coupled and connected to the pole pieces (6) (7), respectively; coupling rods (9) which are made of a magnetic material, and which connect together upper end portions of the magnets (8); and a power source device (10) which applies a discharging voltage to the discharge electrodes (4).

The discharge electrodes (4) are configured by: a central electrode (11) which is formed into a substantially T-like shape (a hammer-like shape); and substantially L-like peripheral electrodes (12) (13) which are placed in a state where they oppose end faces (pointed ends) of the T-like head of the central electrode (11). Each of the central electrode (11) and the peripheral electrodes (12) (13) is formed by a refractory metal such as tungsten or molybdenum.

The power source device (10) is configured by: an AC power source (14); a transformer (15) which boosts an AC current; and pulse voltage applying means (16) consisting of a full-wave rectifier circuit which is placed on the secondary side of the transformer (15), and which is formed by removing away capacitors from a voltage doubler rectifier circuit. One of the secondary terminals of the transformer (15) is electrically connected to the central electrode (11) which is formed into a T-like shape, and the other secondary terminal of the transformer (15) is electrically connected to the peripheral electrodes (12) (13) which are formed into an L-like shape, respectively through high-voltage rectifying diodes (17) (18). In this case, the high-voltage rectifying diode (17) and the high-voltage rectifying diode (18) are placed while their flow directions are opposite to each other, so that the positive electrode (12) outputs a high voltage with respect to the central electrode (11), and the negative electrode (13) outputs a low voltage with respect to the central electrode (11). Namely, as a pulse voltage, the pulse voltage applying means (16) applies alternately positive- and negative-voltage side pulsating waves which are respectively half-wave rectified. A corona discharge is produced between the pointed ends of the central electrode (11) and the positive electrode (12), or between those of the central electrode (11) and the negative electrode (13), and excited species including plasma is produced by the corona discharge.

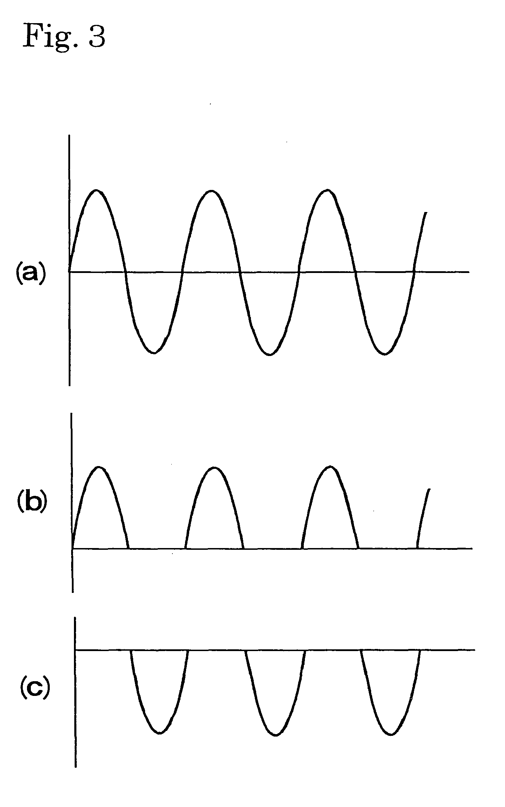

In the power source device (10), the AC power source of 50 Hz to 100 KHz is boosted by the transformer (15) to a sinusoidal wave having a peak value Vp of 5 to 15 KV such as shown in Fig. 3a. The boosted sinusoidal wave is converted to a DC pulsating wave having a peak value Vp of 5 to 15 KV. The positive voltage portions (DC) shown in Fig. 3b are applied between the central electrode (11) and the positive electrode (12), and the negative voltage portions shown in Fig. 3c are applied between the central electrode (11) and the negative electrode (13), whereby, while setting a sum of the ON period and the OFF period as one period T, pulse voltages having a pulse frequency (1/T) of 10 to 200 Hz and a pulse duty of 10 to 100% are alternately generated.

Magnetic field forming means for forming a magnetic field extending along a horizontal plane in which charged particles in plasma produced by the corona discharge exist is disposed in positions proximal to the pointed ends of the discharge electrodes (4). The magnetic field forming means is configured by: the permanent magnets (8) which are placed above basal end portions of the discharge electrodes (4); a pair of soft magnetic members which are made of pure iron or the like, which are connected the both N and S poles of the permanent magnets (8), and which elongate to the vicinities of the pointed ends of the pair of discharge electrodes (4); and a pair of pole pieces (6) (7) which are made of pure iron or the like, which are integrally continuous to the tip ends of the soft magnetic members, and which oppose each other with the pointed ends of the discharge electrodes (4) therebetween to form a magnetic field forming gap between the opposing end faces. In accordance that a charged particle in plasma moves in the magnetic field formed in the gap between the end faces of the pole pieces (6) (7) in the magnetic field forming means, the charged particle undergoes a pushing force, i.e., the Lorentz force, and excited species including plasma are irradiated toward the surface of the workpiece as indicated by the arrow X in Figs. 1 and 2.

When the charge of a particle is Q, the velocity is v, and the magnetic flux density between the end faces of the pole pieces is B, the Lorentz force F is:

$$\mathbf{F} = \mathbf{Q}\mathbf{v} \times \mathbf{B}$$

The force acts perpendicularly to the velocity vector of the charged particle, whereby excited species including plasma are pushed and irradiated in the direction of the arrow X.

A reactive gas such as argon, nitrogen, or carbon dioxide gas, or high-speed air is introduced between the pair of discharge electrodes at the atmospheric pressure or a vicinity of the atmospheric pressure, from the gas ejection holes (1) formed in the plate-like insulating member (3), and an excitation gas flow including plasma is irradiated toward the surface of the workpiece by the Lorentz force received from the magnetic field. Therefore, the applicability of the surface treatment can be expanded.

In the thus configured plasma surface treating apparatus of the corona discharge type, a magnetic field configured by an effective magnetic flux and a leakage magnetic flux is formed in the gap between the end faces of the pole pieces (6) (7) which are connected to the N and S poles of the permanent magnet (8) via the soft magnetic members. In this state, the output rectified by the above-mentioned power source device (10) applies a positive or negative pulse voltage of a frequency of 10 to 200 Hz between the central electrode (10) and the positive electrode (11), and between the central electrode (11) and the negative electrode (12) to alternately produce a corona discharge between the pointed ends of the electrodes (10) (11) or (10) (12). As a result, excited species including plasma produced by the corona discharge exist in the magnetic field. A force in the direction of the arrow X which is perpendicular to the magnetic field is applied to the excited species including plasma by the above-mentioned Lorentz force F that is received from the magnetic field by charged particles in the plasma moving in the magnetic field.

In the invention, a positive or negative pulse voltage configured by plural pulsating waves obtained by rectifying an AC voltage is used in the central electrode (11) and positive and negative electrodes (12) (13) which constitute the pair of discharge electrodes (4). Therefore, a special pulse voltage generating power source such as a multivibrator, a Schmidt trigger circuit, or a blocking oscillator is not required, and a pulse voltage of a desired period and duty can be applied by using a simple power source device configured by a combination of a commercial AC power source or an ultrasonic power source and rectifying elements such as diodes. Moreover, the permanent magnet (8) which can be produced at a low cost, and which does not consume an electric power is used as the magnetic field forming means. As a result, the introduction cost and running cost of the whole apparatus can be reduced.

In the embodiment, the permanent magnet (8) is used as the magnetic field forming means (M). Alternatively, an electromagnet may be used as the magnetic field forming means. When an electromagnet is used as the magnetic field forming means (M) as described above, the Lorentz force F can be controlled, and the force which is loaded on excited species including plasma, and which is perpendicular to the magnetic field can be adjusted.

In the embodiment, the magnetic field is formed between the end faces opposing each other across the pointed ends of the discharge electrodes (4), and a reactive gas or high-speed air is ejected between the end faces. Alternatively, only one of the magnetic field formation and the gas introduction may be employed.

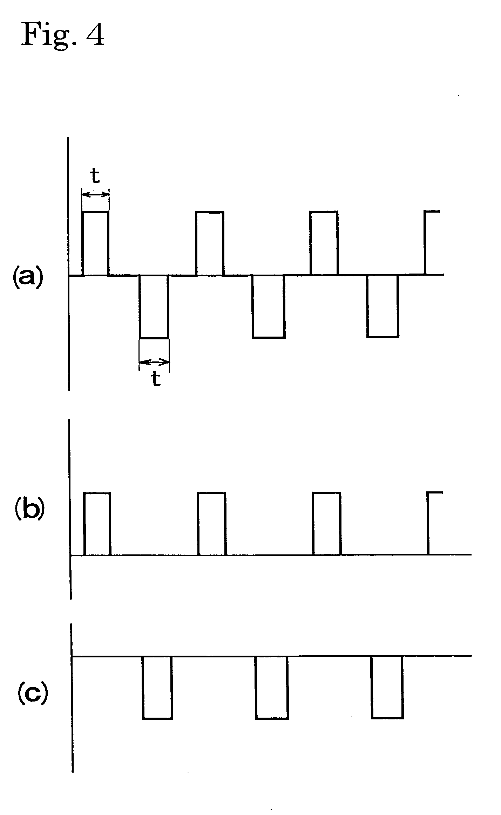

In the embodiment, the pulse voltage applying means configured by the AC power source and the rectifier circuit for generating a pulse voltage formed by plural pulsating waves which are obtained by full-wave rectifying the AC voltage has been described. Alternatively, the pulse voltage applying means may be a pulse voltage generating power source which generates a rectangular pulse voltage such as shown Fig. 4.

Industrial Applicability

The invention can be mainly applied to various surface treatments such as those of, in the case where application of a coating composition or printing is performed on a resin such as polyethylene, polypropylene, polyester (PET), or PTFE (polytetrafluoroethylene), modifying the water repellent property of the surface to the water-attracting property, washing away organics adhering to the surface of glass, ceramics, a metal, a semiconductor, or the like, conducting disinfection or sterilization, and performing an etching process, or a decomposition process using molecular dissociation due to plasma produced by a corona discharge.

**Claims**

**1.** A plasma treating method in which a pulse voltage is applied between discharge electrodes (4) which are opposingly positioned, to produce a corona discharge between pointed ends of said discharge electrodes (4), and a surface of a workpiece is irradiated with excited species including plasma produced by the corona discharge, thereby treating said surface, wherein

the pulse voltage is alternately applied by pulse voltage applying means (16) configured with using an even voltage doubler rectifier circuit to a central electrode (11) and two peripheral electrodes (12) (13) of said discharge electrodes (4), said discharge electrodes being configured by said central electrode (11) and said two peripheral electrodes (12) (13) opposingly placed in a state where said central electrode (11) is interposed between said peripheral electrodes, and the corona discharge is alternately generated between one of said two peripheral electrodes (12) (13) and said central electrode (11).

**2.** A plasma treating method according to claim 1, wherein a rectangular pulse voltage is used as the pulse voltage.

**3.** A plasma treating method according to claim 1, wherein a pulse voltage configured by plural pulsating waves which are obtained by full-wave rectifying an AC voltage is used as the pulse voltage.

**4.** A plasma treating method according to any one of claims 1 to 3, wherein a magnetic field is formed in vicinities of said pointed ends of said discharge electrodes (4) and in places where charged particles in the plasma exist, and the excited species including plasma are irradiated toward said surface of said workpiece by a pushing force acting on charged particles moving in the magnetic field.

**5.** A plasma treating method according to any one of claims 1 to 4, wherein a reactive gas is introduced between said central electrode (11) and said peripheral electrodes (12) (13) opposing said central electrode (11) at atmospheric pressure or a vicinity of atmospheric pressure, whereby an excitation gas flow including plasma is caused to be irradiated toward said surface of said workpiece.

**6.** A plasma treating apparatus in which a pulse voltage is applied between discharge electrodes (4) which are opposingly positioned, to produce a corona discharge between pointed ends of said discharge electrodes, and a surface of a workpiece is irradiated with excited species including plasma produced by the corona discharge, thereby treating said surface, wherein

said discharge electrodes (4) are configured by a central electrode (11) and two peripheral electrodes (12) (13) placed to oppose said central electrode (11), a center terminal of pulse voltage applying means (16) configured with using an even voltage doubler rectifier circuit is connected to said central electrode (11), side terminals of said pulse voltage applying means (16) are connected to said peripheral electrodes (12) (13), respectively, and, based on an alternating voltage applied to said central electrode (11) and said peripheral electrodes (12) (13), the corona discharge is alternately generated between said central electrode (11) and said peripheral electrodes (12) (13).

**7.** A plasma treating apparatus according to claim 6, wherein said central electrode (11) is formed into a hammer-like shape, and said peripheral electrodes (12) (13) are placed in a state where said peripheral electrodes oppose tip end portions of arms which are extended in opposing directions.

**8.** A plasma treating apparatus according to claim 6 or 7, wherein said pulse voltage applying means (16) is a rectangular-pulse voltage generating power source.

**9.** A plasma treating apparatus according to claim 6 or 7, wherein said pulse voltage applying means (16) is configured by an AC power source, and a rectifier circuit which generates a pulse voltage formed by plural pulsating waves obtained by full-wave rectifying the AC voltage.

**10.** A plasma treating apparatus according to any one of claims 6 to 9, wherein magnetic field forming means (M) is disposed, said magnetic field forming means forming a magnetic field in vicinities of said pointed ends of said discharge electrodes (4) which are opposingly placed, and in places where charged particles in the plasma exist, to be able to apply a pushing force to a charged particle moving in the magnetic field, the pushing force causing excited species including plasma to be irradiated toward surface of said workpiece.

**11.** A plasma treating apparatus according to claim 10, wherein said magnetic field forming means (M) is configured by: a permanent magnet (8); a pair of magnetic members which are connected to N and S poles of said permanent magnet (8), and which elongate to vicinities of said pointed ends of said pair of discharge electrodes (4); and a pair of pole pieces (6) (7) which are continuous to tip ends of said magnetic members, and which form a gap between end faces.

**12.** A plasma treating apparatus according to claim 10, wherein said magnetic field forming means (M) is configured by: an electromagnet connected to a DC power source; a pair of magnetic members which are connected to N and S poles of said electromagnet, and which elongate to vicinities of said pointed ends of said pair of discharge electrodes (4); and a pair of pole pieces (6) (7) which are continuous to tip ends of said magnetic members, and which form a gap between end faces.

**13.** A plasma treating apparatus according to any one of claims 6 to 12, wherein means for introducing a reactive gas between said discharge electrodes at atmospheric pressure or a vicinity of atmospheric pressure is disposed, and the reactive gas is introduced via said means, whereby an excitation gas flow including plasma is caused to be irradiated toward said surface of said workpiece.

Fig. 1

Fig. 2

# Fig. 3

(a)

(b)

(c)

Fig. 4

## INTERNATIONAL SEARCH REPORT

| International application No. |
| --- |
| PCT/JP2004/012470 |

A.  CLASSIFICATION OF SUBJECT MATTER
Int.Cl⁷ H05H1/24, C08J7/00, B01J19/08

According to International Patent Classification (IPC) or to both national classification and IPC

B.  FIELDS SEARCHED

Minimum documentation searched (classification system followed by classification symbols)
Int.Cl⁷ H05H1/24, C08J7/00, B01J19/08

Documentation searched other than minimum documentation to the extent that such documents are included in the fields searched
Jitsuyo Shinan Koho        1940–1996    Toroku Jitsuyo Shinan Koho   1994–2004
Kokai Jitsuyo Shinan Koho   1971–2004    Jitsuyo Shinan Toroku Koho   1996–2004

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| Y | JP 2002-158219 A  (Sekisui Chemical Co., Ltd.), 31 May, 2002 (31.05.02), Par. Nos. [0024] to [0028], [0044]; Figs. 1 to 4 (Family: none) | 1-13 |
| Y | JP 7-226395 A  (Matsushita Electric Industrial Co., Ltd.), 22 August, 1995 (22.08.95), Par. Nos. [0014] to [0019]; Figs. 1, 2, 10 to 14 & US 5609690 A1 | 1-13 |
| Y | JP 5-59198 A  (Softal Electronic GmbH), 09 March, 1993 (09.03.93), Par. Nos. [0019] to [0046]; Figs. 3, 4, 10, 13 (Family: none) | 1-13 |

| ☒  Further documents are listed in the continuation of Box C. | ☐  See patent family annex. |
| --- | --- |

*       Special categories of cited documents:
"A"   document defining the general state of the art which is not considered to be of particular relevance
"E"   earlier application or patent but published on or after the international filing date
"L"   document which may throw doubts on priority claim(s) or which is cited to establish the publication date of another citation or other special reason (as specified)
"O"   document referring to an oral disclosure, use, exhibition or other means
"P"   document published prior to the international filing date but later than the priority date claimed

"T"   later document published after the international filing date or priority date and not in conflict with the application but cited to understand the principle or theory underlying the invention
"X"   document of particular relevance; the claimed invention cannot be considered novel or cannot be considered to involve an inventive step when the document is taken alone
"Y"   document of particular relevance; the claimed invention cannot be considered to involve an inventive step when the document is combined with one or more other such documents, such combination being obvious to a person skilled in the art
"&"   document member of the same patent family

| Date of the actual completion of the international search | Date of mailing of the international search report |
| --- | --- |
| 15 November, 2004 (15.11.04) | 30 November, 2004 (30.11.04) |

| Name and mailing address of the ISA/ Japanese Patent Office | Authorized officer |
| --- | --- |
| Facsimile No. | Telephone No. |

Form PCT/ISA/210 (second sheet) (January 2004)

## INTERNATIONAL SEARCH REPORT

| | International application No. |
|---|---|
| | PCT/JP2004/012470 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-332572 A (Semiconductor Energy Laboratory Co., Ltd.), 22 November, 2002 (22.11.02), Par. Nos. [0023], [0028]; Fig. 1 (Family: none) | 1-13 |
| Y | JP 11-512651 A (Seondo Electric Co., Ltd.), 02 November, 1999 (02.11.99), Page 14, line 22 to page 15, line 1; page 15, lines 18 to 28; page 20, line 10 to page 21, line 1; Figs. 5, 9 & WO 97/24515 A1 & US 6168689 B1 | 1-13 |
| Y | JP 2002-305070 A (Toto Ltd.), 18 October, 2002 (18.10.02), Par. Nos. [0012] to [0020]; Figs. 1, 2 (Family: none) | 1-13 |
| Y | JP 2003-86393 A (Keyence Corp.), 20 March, 2003 (20.03.03), Full text; all drawings (Family: none) | 1-13 |
| Y | JP 11-60759 A (Sekisui Chemical Co., Ltd.), 05 March, 1999 (05.03.99), Par. Nos. [0015] to [0037]; Figs. 1 to 7 (Family: none) | 1-13 |

Form PCT/ISA/210 (continuation of second sheet) (January 2004)